# EUROPEAN PATENT APPLICATION

(11) **EP 4 531 111 A1**
(43) Date of publication of application: **02.04.2025**
(21) Application number: 23199766.9
(22) Date of filing: 26.09.2023
(51) Int. Cl.: H01L 29/40, H01L 29/423, H01L 29/51, H01L 29/66, H01L 29/739, H01L 29/78, H01L 29/06

(54) **SEMICONDUCTOR DEVICES AND METHOD FOR MANUFACTURING A SEMICONDUCTOR DEVICE**

(71) Applicant: Infineon Technologies Austria AG, 9500 Villach (AT)
(72) Inventor: OLES, Peter, 9500 Villach (AT); BLANK, Oliver, 9500 Villach (AT)
(74) Representative: Infineon Patent Department

(57) **Abstract**

A semiconductor device comprises a semiconductor body (101) comprising a first major surface (101a), a source region (114b) of a first conductivity type, a body region (114a) of a second conductivity type opposing the first conductivity type, and a drift region (112) of the first conductivity type. At least one trench (120) is formed in the semiconductor body in a direction that is orthogonal to the first major surface. The at least one trench comprises a sidewall (120b) and a base (120a). The semiconductor device further comprises an electrode (244) arranged in the at least one trench. The semiconductor device further comprises a cavity (126) arranged in the at least one trench and located between the electrode and the drift region. The semiconductor device further comprises a first dielectric layer (241) disposed at least on a portion of the electrode, wherein the first dielectric layer has a thickness greater or equal to 2 nm and less or equal to 50 nm.

## Description

### TECHNICAL FIELD

Embodiments described herein relate to methods for forming semiconductor devices having cavities. Further embodiments described herein relate to semiconductor devices having such cavities.

### BACKGROUND

Conducting structures integrated into semiconductor devices needs to be electrically insulated from other parts of the device to ensure reliable functioning of the semiconductor device. Examples of such conducting structures are field electrodes and gate electrodes which are insulated from the semiconductor substrate by insulation layers such as oxide layers. As comparably high voltages may occur between field electrodes (or gate electrodes) and the semiconductor substrate during operation of the semiconductor device, the insulation layer needs to be thick to prevent electrical breakdown. However, thick insulation layers need more space as compared to thin insulation layers and increases the size of the respective device.

US 10,355,126 B2 discloses a power semiconductor device where an electrode is electrically insulated from a semiconductor body by a cavity formed in an electrode trench between the electrode and the semiconductor body. While a cavity (e.g., filled with a vacuum or a gas) may allow comparably high voltages with reduced spacing between semiconductor body and electrode, field emission may still occur which may lead to current flow from the electrode to the semiconductor body over the cavity. In view of the above, there may be a need for improvement.

### SUMMARY

A semiconductor device may comprise a semiconductor body comprising a first major surface, a source region of a first conductivity type, a body region of a second conductivity type opposing the first conductivity type, and a drift region of the first conductivity type. The semiconductor device may further comprise at least one trench formed in the semiconductor body in a direction that is orthogonal to the first major surface. The at least one trench may comprise a sidewall and a base. The semiconductor device may further comprise an electrode arranged in the at least one trench. The semiconductor device may further comprise a cavity arranged in the at least one trench and located between the electrode and the drift region. The semiconductor device may further comprise a first dielectric layer disposed at least on a portion of the electrode, wherein the first dielectric layer has a thickness that may be greater or equal to 2 nm and less or equal to 50 nm.

A method for processing a semiconductor device may comprise forming at least one trench on a first main surface of a semiconductor body. The semiconductor body may comprise a source region of a first conductivity type, a body region of a second conductivity type opposing the first conductivity type, and a drift region of the first conductivity type. The at least one trench may be formed in the semiconductor body in a direction that is orthogonal to the first major surface and may comprise a sidewall and a base. The method may further comprise forming at least one auxiliary layer on the base and the sidewall of the at least one trench. The method may further comprise forming a first dielectric layer at least on a portion of the at least one auxiliary layer and within the at least one trench, the first dielectric layer having a thickness that is greater or equal to 2 nm and less or equal to 50 nm. The method may further comprise forming a filling material directly on the first dielectric layer and within the at least one trench, wherein the filing material comprises an electrically conductive material. The method may further comprise forming a sealing structure that at least partially covers the at least one trench and that comprises at least one opening. The method may further comprise removing the at least one auxiliary layer from the at least one trench to form a cavity within the at least one trench whilst leaving the first dielectric layer within the at least one trench.

A method for processing a semiconductor device may comprise forming at least one trench on a first main surface of a semiconductor body. The semiconductor body may comprise a source region of a first conductivity type, a body region of a second conductivity type opposing the first conductivity type, and a drift region of the first conductivity type. The at least one trench may be formed in the semiconductor body in a direction that is orthogonal to the first major surface and may comprise a sidewall and a base. The method may further comprise forming at least one auxiliary layer on the base and the sidewall of the at least one trench. The method may further comprise forming a filling material on the at least one auxiliary layer and within the at least one trench. The filing material may comprise an electrically conductive material. The method may further comprise forming a sealing structure that at least partially covers the at least one trench and that comprises at least one opening. The method may further comprise removing the at least one auxiliary layer from the at least one trench to form a cavity within the at least one trench. The method may further comprise forming a first dielectric layer on at least a portion of the filling material and within the at least one trench, the first dielectric layer having a thickness t that is greater or equal to 2 nm and less or equal to 50 nm.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Figure 1A illustrates a semiconductor device according to an embodiment.
Figure 1B illustrates an energy barrier in relation to a distance according to embodiments.
Figure 1C illustrates a field emission in relation to a thickness of a dielectric layer according to embodiments.
Figures 2A to 2L illustrate, in a cross-sectional view of a semiconductor body, processes according to an embodiment.
Figures 3A and 3B illustrate, in a cross-sectional view of a semiconductor body, processes according to an embodiment.
Figure 4 illustrates, a method for processing a semiconductor device according to an embodiment.
Figure 5 illustrates, a method for processing a semiconductor device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention.

The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore may run in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there may be no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there may be no intervening elements present.

In some embodiments, the semiconductor device is a transistor device and may be a MOSFET (Metal Oxide Semiconductor Field Effect Transistor) device, a superjunction transistor device or an insulated gate bipolar transistor (IGBT) device. The transistor device may be a vertical transistor device with a drift path that extends substantially perpendicularly to the major surfaces of the device.

The regions and terminals of the transistor device are referred to herein as source, drain and gate regions / terminals. As used herein, these terms also may encompass the functionally equivalent regions / terminals of other types of transistor devices, such as an insulated gate bipolar transistor (IGBT). For example, as used herein, the term "source" region / terminal may encompass not only a source region / terminal of a MOSFET device and of a superjunction device but also an emitter region / terminal of an insulator gate bipolar transistor (IGBT) device, the term "drain" region / terminal may encompass not only a drain of a MOSFET device or of a superjunction device but also a collector of an insulator gate bipolar transistor (IGBT) device and a collector of a BJT device, and the term "gate" region / terminal may encompass not only a gate of a MOSFET device or of a superjunction device but also a gate of an insulator gate bipolar transistor (IGBT) device.

Some embodiments are described next with reference to the Figures. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

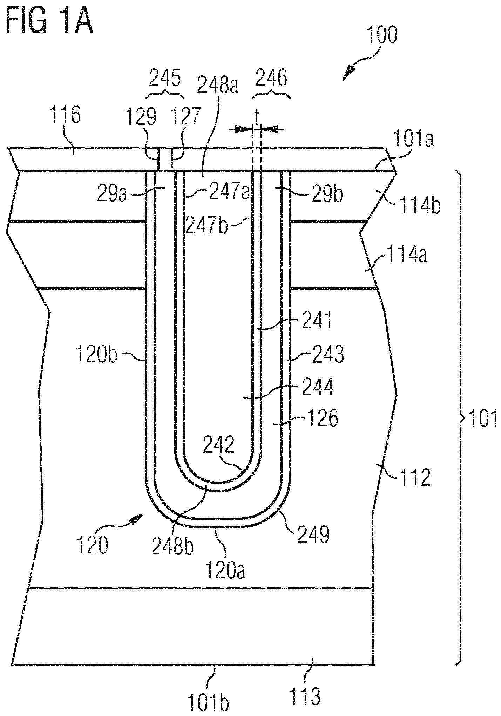

Figure 1A illustrates a semiconductor device 100 according to an embodiment. In embodiments, the semiconductor device 100 may be a transistor device (such as a vertical power transistor device). The semiconductor device 100 comprises a semiconductor body 101, at least one trench 120, an electrode 244, a cavity 126, and a first dielectric layer 241.

The semiconductor body 101 comprises a first major surface 101a (such as an upper surface), a source region 114b, a body region 114a, and a drift region 112. In some embodiments, semiconductor body may comprise a drain region 113 arranged below the drift region 112. The semiconductor body 101 may comprise (e.g., be made of) one of silicon, silicon carbide, and gallium nitride. In embodiments, the semiconductor body 101 may be formed of monocrystalline material or an epitaxially deposited layer (such as an epi layer). In the latter case, the semiconductor body 101 may comprise one or more epitaxial deposited layers formed on a base substrate, for example an epitaxial silicon layer formed on a silicon wafer.

Source region 114b may be of a first conductivity type (such as n-type), body region 114a may be of a second conductivity type (such as p-type) opposing the first conductivity type, and drift region 112 may be of the first conductivity type (such as n-type). The body region 114a may be arranged on and may form a pn junction with the drift region 112. The source region 114b may be arranged on and/or in the body region 114a.

One or more trenches 120 are formed in the semiconductor body 101 in a direction that is orthogonal to the first major surface 101a (such as in the vertical direction). Each of the one or more trenches 120 may comprise sidewall 120b and base 120a. In some embodiments, the one or more trenches 120 may have an elongate striped-like form with the longest direction extending into the plane of the drawing. In these embodiments, the sidewall 120b of a trench 120 may have four side wall sections with adjoining sections extending substantially perpendicularly to one another to form a rectangular striped trench 120. In other embodiments, the trench 120 may have a columnar or needle type shape (then the trench 120 may be referred to as columnar trench). If the columnar trench 120 is circular in plan view, it may have a single sidewall 120b. If the columnar trench 120 is, for example square or hexagonal in plan view, the sidewall 120b of the columnar trench 120 may have four and six side wall sections, respectively, whereby adjoining sections extend at an angle to one another, e.g. substantially perpendicularly or around 60°.

The sidewall 120b of the trench 120 may extend substantially perpendicularly to the first major surface 101a or the trench 120 may taper slightly such that the base 120a may have a smaller area than the opening of the trench 120 at the first major surface 101a. The base 120a of the trench 120a may be substantially parallel to the first major surface 101a or have a concave form.

One or more electrodes 244 may be arranged in each of the one or more trenches 120. The electrodes 244 may be at least one of a field plate and a gate electrode. In an embodiment, the electrode 244 may be an electrically conductive field plate that is arranged in the trench 120 having an upper surface that is substantially coplanar with the first major surface 101a of the semiconductor body 101. The field plate may be formed of electrically conductive material such as n-doped polysilicon and may be electrically insulated from the semiconductor body at least in part by cavity 126 arranged in the trench 120. In another embodiment, the electrode 244 may be a gate electrode that is arranged in the trench 120. The gate electrode may be formed of an electrically conductive material, such as n-doped polysilicon or metal.

Electrode 244 may comprise a first sidewall 247a, a second sidewall 247b opposing the first sidewall, an upper surface 248a and a lower surface 248b. The first sidewall 247a and the second sidewall 247a may be arranged substantially orthogonal to the first major surface 101a or may taper such that the lower surface 248b may have a smaller area than the upper surface 248a of the electrode or taper such that the lower surface 248b may have a larger area than the upper surface 248a of the electrode. The lower surface 248b may at least in parts be substantially parallel with the first major surface 101a or may have a rounded shape. The upper surface 248a may be substantially parallel with the first major surface 101a and may be coplanar with the first major surface 101a (as exemplarily indicated in Fig. 1A) or may lie below the first major surface 101a and may be covered with an insulating material (not shown in Fig. 1A).

In some embodiments (not shown in Fig. 1A), the electrode 244 may be insulated from the semiconductor body by a shielding structure that comprises cavity 126 and a shielding layer.

In that case, the shielding layer may, e.g., be arranged between the electrode 244 and the source region 114b, the body region 114a, and an upper part of the drift region 112 and cavity 126 may be arranged between a lower part of the drift region 112 and the electrode. In some embodiments, an anchoring structure may be present that is arranged between the lower surface 248b of electrode 244 and the base 120a of trench 120.

In case electrode 244 is a gate electrode, electrode 244 may be connected to a gate terminal via one or more gate connections (such as, gate fingers, gate runners and/or gate pad) so that a gate potential may be applied to electrode 244. In case electrode 244 is a field plate, electrode 244 may be connected to a source terminal via one or more source connections (such as, source fingers, source runners and/or source pad).

Cavity 126 may be arranged in each of the one or more trenches 120. In particular, cavity 126 may be located between the electrode 244 and at least a part of the drift region 112 (such as a lower part). Cavity 126 may be empty, i.e. free of solid material, and may be vacuum-filled or gas-filled. Cavity 126 may have a dielectric constant which is less than the dielectric constant of solid material typically used as a shield dielectric, such as silicon oxide. In some examples, the dielectric constant of cavity 126 may be substantially equal to the dielectric constant of vacuum or air.

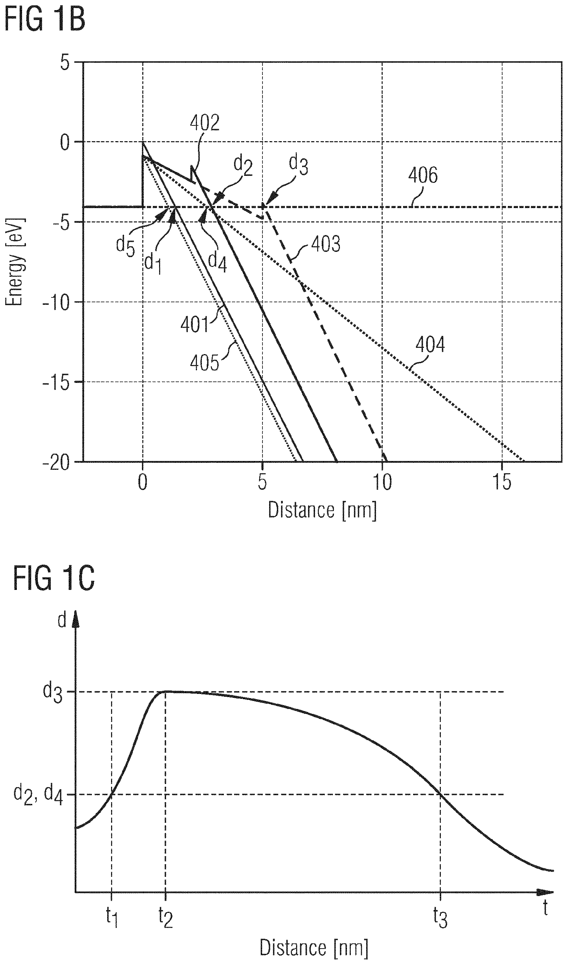

Still referring to Fig. 1A, first dielectric layer 241 may be disposed at least on a portion 242 of electrode 244. The first dielectric layer 241 may comprise (e.g., be made of) one or more of silicon oxide, silicon nitride, aluminum oxide, titanium oxide, hafnium oxide, zirconium oxide, hafnium silicate, zirconium silicate, tantalum oxide, praseodymium oxide, lanthanum oxide, lanthanum aluminum oxide, niobium oxide, SiCOH, and a high-k material. In a particular embodiment, the first dielectric layer 241 may comprise (e.g., be made of) one or more of silicon oxide. The first dielectric layer 241 has a thickness t that is greater than or equal to 2 nm and less or equal to 50 nm. In embodiments the thickness t of the first dielectric layer 241 may be less or equal to 30 nm. In embodiments the thickness t of the first dielectric layer 241 may be less or equal to 20 nm. In embodiments the thickness t of the first dielectric layer 241 may be greater or equal to 2.5 nm. In embodiments the thickness t of the first dielectric layer 241 may be greater or equal to 3 nm. In some embodiments, the first dielectric layer 241 has a thickness t that is greater than 2.5 nm and less or equal to 30 nm. In embodiments, the first dielectric layer 241 has a thickness t hat is greater than 3 nm and less or equal to 20 nm. A first dielectric layer 241 with a thickness of, e.g., in a range from 2 nm to 50 nm and disposed on electrode 244 may reduce a field emission from electrode 244 to the semiconductor body 101 over cavity 126, as further explained with reference to Fig. 1B and 1C.

The at least one portion 242 of the electrode on which the first dielectric layer 241 is disposed may be located where the surface of electrode 244 has a curved shape (e.g., where the surface of the electrode 244 exhibits a curvature), such as where the first sidewall 247a of the electrode 244 meets the lower surface 248b of the electrode 244 and/or where the second sidewall 247b of the electrode meets the lower surface 248b of the electrode 244. In some embodiments, the first dielectric layer 242 is only disposed on the at least one portion 242 of the electrode 244. In other embodiments, the first dielectric layer 242 covers the first sidewall 247a, the second sidewall 247b and the lower surface 248b of the electrode completely.

The semiconductor device 100 may further comprise a second dielectric layer 243 that may be disposed at least on a portion 249 of one or more of the first sidewall 120b, the second sidewall 120a and the lower surface 248b of the trench 130. The second dielectric layer 243 may comprise (e.g., be made of) one or more of silicon oxide, silicon nitride, aluminum oxide, titanium oxide, hafnium oxide, zirconium oxide, hafnium silicate, zirconium silicate, tantalum oxide, praseodymium oxide, lanthanum oxide, lanthanum aluminum oxide, niobium oxide, SiCOH, and a high-k material. In one embodiment, the second dielectric layer 243 may have a thickness that is less than or equal to the thickness of the first dielectric layer 242. In another embodiment, the second dielectric layer 243 may have a thickness that is larger than the thickness of the first dielectric layer 242.The semiconductor device 100 may further comprise a sealing structure 116 covering the cavity 126. The sealing structure 116 may close (such as seal) the cavity 126 so that a vacuum or gas (e.g., air) positioned in the cavity 126 may be stored in the cavity 126. The sealing structure 116 may comprise or consist of one or more insulating layers. Alternatively, the sealing structure 116 may comprise one or more contact structures that, e.g., may be used to contact electrode 144 (not shown in Figure 1A), as discussed, e.g., in US 10,355,126 B2, which is incorporated herein by reference. The sealing structure 116 may likewise comprise both one or more insulating layers and one or more contact structures. In Fig. 1A the sealing structure 116 is indicated by a single layer only for illustrative purposes.

Sealing structure 116 may comprise an opening 129 that may be filled (such as sealed) with a plug 127. In embodiments, opening 129 may be used in a method for processing the semiconductor device 100, e.g., for forming cavity 126 (such as by removing an auxiliary structure from the trench 130 through opening 129).

Sealing structure 116 when viewed in a plane that is orthogonal to the first major surface 101a may comprise a first portion 245 and a second portion 246. The first portion 245 of sealing structure 116 may span from a first sidewall 120a of the trench 130 to a first sidewall 247a of electrode 244. The second portion 246 of sealing structure 116 may span from a second sidewall 120a of the trench 130 to a second sidewall 247b of the electrode 244.

In some embodiments, opening 129 may have a width that is greater than one or more of a sum of the thickness t of the first dielectric layer 241 and a thickness of the second dielectric layer 243, twice the thickness of the first dielectric layer 241, and twice the thickness of the second dielectric layer 243.

Plug 127 may comprise (e.g., may be made of) one or more of silicon oxide, carbon, silicon nitride, aluminum oxide, poly silicon, SiOF, SiOCH, and a silicate glass (such as borosilicate glass, phosphosilicate glass borophosphosilicate glass).

Figure 1B schematically illustrates an energy (in electronvolts) versus a distance (in nano meters) from an electrode (such as electrode 244) for several exemplary embodiments.

Line 401 indicates a plot of an energy versus distance from an electrode (such as electrode 244 shown in Fig. 1A) in case a cavity is present (such as cavity 126 shown in Fig. 1A) in an electrode trench (such as trench 120 shown in Fig. 1A) of the electrode without a dielectric layer (such as dielectric layer 241 shown in Fig. 1A) being disposed on the electrode. The energy of line 401 exhibits a maximum value where the electrode ends (at distance equal 0 nm) and the cavity starts. In addition, the energy of line 401 exhibits a uniform slope. An electron that is present on the electrode may be emitted from the electrode in case it can cross the energy barrier (e.g., via tunnelling from the electrode to the cavity). This effect is known as field emission and may be undesirable. The magnitude of the tunnelling current roughly depends exponentially on the thickness d of the tunnelling barrier, which is given by the part of the plot of the energy that is larger or equal to the potential of the electrons on the electrode. It is generally known that the larger the distance d of the energy barrier is, the smaller is the tunneling current. The distance d of the tunnelling barrier of line 401 is indicated as d₁ in Fig. 1B. The line 406 indicates the potential of the electrons on the electrode.

As discuss with regard to Fig. 1A and as also further discussed in the following, arranging a dielectric layer (such as dielectric layer 241) on electrode 244 may reduce field emission.

Line 402 indicates a plot of an energy versus distance from an electrode (such as electrode 244 shown in Fig. 1A) in case a cavity is present (such as cavity 126 shown in Fig. 1A) in an electrode trench (such as trench 120 shown in Fig. 1A) of the electrode and a dielectric layer (such as dielectric layer 241 shown in Fig. 1A) being disposed on the electrode. The dielectric layer 241 in the embodiment shown by line 402 is 2 nm (which may be seen in line 402 at the point on line 241 where the distance is 2 nm, and where a different slope of the line is present for distances that are smaller than 2nm as compared to distances that are larger than 2 nm). It can be seen, that the distance d of the tunneling barrier of line 402 (being indicated as d₂) increases for line 402 where a dielectric layer is present on the electrode as compared to the distance d₁ of the tunneling barrier of line 401 where no dielectric layer is present on the electrode.

Line 403 indicates a plot of an energy versus distance from an electrode (such as electrode 244 shown in Fig. 1A) in case a cavity is present (such as cavity 126 shown in Fig. 1A) in an electrode trench (such as trench 120 shown in Fig. 1A) of the electrode and a dielectric layer (such as dielectric layer 241 shown in Fig. 1A) being disposed on the electrode. The dielectric layer 241 in the embodiment shown by line 403 is 5 nm (which may be seen in line 402 at the point on line 241 where the distance is 5 nm, and where a different slope of the line is present for distances that are smaller than 5nm as compared to distances that are larger than 5 nm). It can be seen, that the distance d of the tunneling barrier of line 403 (being indicated as d₃) increases for line 403 where a dielectric layer is present on the electrode as compared to the distance d₁ of the tunneling barrier of line 401 where no dielectric layer is present on the electrode. It can further be seen, that the distance d of the tunneling barrier of line 403 (being indicated as d₃) increases for line 403 where a thicker dielectric layer (such as 5 nm) is present on the electrode as compared to the distance d₂ of the tunneling barrier of line 402 where a thinner dielectric layer (such as 2 nm) is present on the electrode.

Line 404 indicates a plot of an energy versus distance from an electrode (such as electrode 244 shown in Fig. 1A) in case a cavity is present (such as cavity 126 shown in Fig. 1A) in an electrode trench (such as trench 120 shown in Fig. 1A) of the electrode and a dielectric layer (such as dielectric layer 241 shown in Fig. 1A) being disposed on the electrode. The dielectric layer 241 in the embodiment shown by line 404 is 50 nm. It can be seen, that the distance d of the tunneling barrier of line 404 (being indicated as d₄) increases for line 404 where a dielectric layer is present on the electrode as compared to the distance d₁ of the tunneling barrier of line 401 where no dielectric layer is present on the electrode. It can further be seen, that the distance d of the tunneling barrier of line 404 (being indicated as d₄) decreases where a thicker dielectric layer (such as 50 nm) is present on the electrode as compared to the distance d₃ of the tunneling barrier of line 403 where a thinner dielectric layer (such as 5 nm) is present on the electrode. It can further be seen, that the distance d of the tunneling barrier of line 404 (being indicated as d₄) where a thicker dielectric layer (such as 50 nm) is present on the electrode is roughly equal to the distance d₂ of the tunneling barrier of line 402 where a thinner dielectric layer (such as 2 nm) is present on the electrode.

Line 405 indicates a plot of an energy versus distance from an electrode such as electrode 244 shown in Fig. 1A) in case no cavity is present (such as cavity 126 shown in Fig. 1A) in an electrode trench (such as trench 120 shown in Fig. 1A) of the electrode and a dielectric layer (such as dielectric layer 241 shown in Fig. 1A) being disposed on the electrode that fills the remainder of the electrode trench. It can be seen that the distance d of the tunneling barrier of line 405 (being indicated as d₅) further decreases as compared to the tunneling barrier of line 404 (indicated as d₄).

According to the present disclosure, it was found that there exists a range for a thickness of a dielectric layer that is arranged on the electrode which leads to a decrease of field emission. As indicated in Fig. 1B this range of the thickness of the dielectric layer may lay between 2 nm and 50 nm, with a maximum of the decreases being obtained for a thickness of around 5 nm.

This is further illustrated in Fig. 1C, which illustrates exemplarily how the distance d of the tunnelling barrier changes based on the thickness t of the dielectric layer arranged on the electrode and arranged between the cavity and the electrode. As indicated by Fig. 1C a desirable range for the thickness of the dielectric layer may lay between 2 nm and 50 nm with a maximum value of the distance d at around 5 nm. Further desirable ranges of the thickness of the dielectric layer may be between 2.5 nm and less or equal to 30 nm. In embodiments, the first dielectric layer 241 has a thickness t that is greater than 3 nm and less or equal to 20 nm. For a thickness of the dielectric layer that is smaller than 2 nm or larger than 50 nm, reduction of field emission may be less prominent as compared to a thickness between 2 nm and 50 nm.

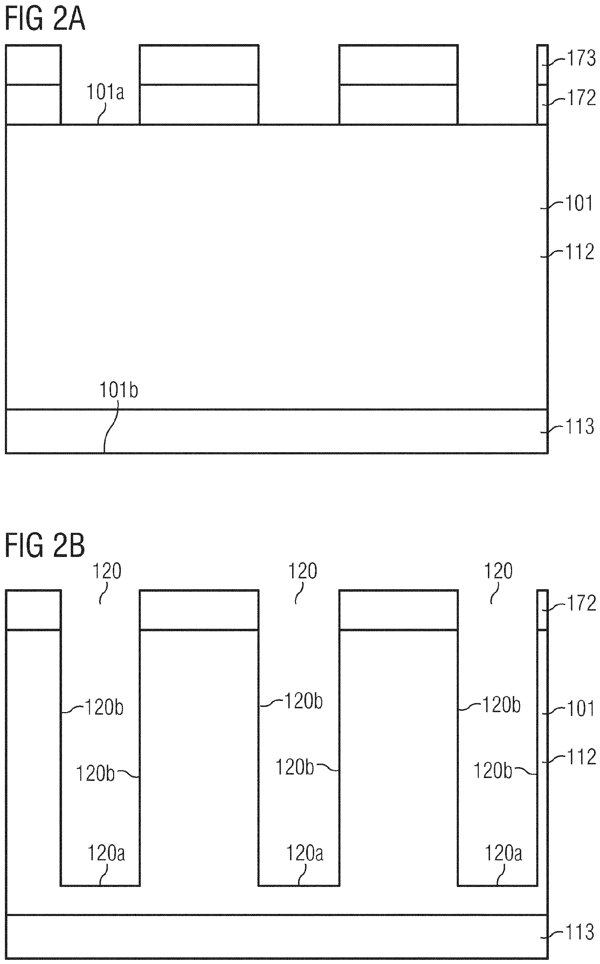

Figures 2A to 2L illustrate, in a cross-sectional view of a semiconductor body, a process according to an embodiment.

Fig. 2A shows a semiconductor body 101. The semiconductor body 101 can have first major surface 101a. Further, the semiconductor body 101 can have a second major surface 101b opposite the first major surface 101a. According to embodiments, the semiconductor body 101 includes a drift region 112 which can be made of a first doping type (such as n-type). In one example the drift region 112 may be lightly n-doped. Further, the semiconductor body 101 can include a drain region 113 which can be made of the first doping type. In one example, the drain region 113 may be highly n-doped. The drain region 113 can be provided at the second major surface site 101b of the semiconductor body 101. According to an embodiment, the drift region 113 may be formed by implantation at a later stage.

For instance, the semiconductor body 101 can be made of any semiconductor material suitable for manufacturing semiconductor components. Examples of such materials include, without being limited thereto, elementary semiconductor materials such as silicon (Si), group IV compound semiconductor materials such as silicon carbide (SiC) or silicon germanium (SiGe), binary, ternary or quaternary III-V semiconductor materials such as gallium arsenide (GaAs), gallium phosphide (GaP), indium phosphide (InP), gallium nitride (GaN), aluminum gallium nitride (AlGaN), indium gallium phosphide (InGaPa) or indium gallium arsenide phosphide (InGaAsP), and binary or ternary II-VI semiconductor materials such as cadmium telluride (CdTe) and mercury cadmium telluride (HgCdTe) to name fewln a particular embodiment, the semiconductor body is made of at least one of Si, SiC, GaN. In an embodiment, the semiconductor body 101 may include an epitaxially grown layer which may form the drift region 113. The semiconductor body 101 may comprise further doped regions such as a body regions having a second doping type (such as p-type) forming pn-junctions with the drift region 113 can be integrated into the semiconductor body 101 (not shown in Fig. 2A). According to embodiments, the semiconductor body 101 can include Si which is doped by As or P. Specifically, a doping concentration of As or P can be higher in the drain region 113 than in the drift region 112.

Still referring to Fig. 2A, a hard mask 172 can be formed on the semiconductor body 101 on the first major surface 101a of the semiconductor body 101. For instance, the hard mask 172 can be formed by depositing an inorganic material such as an oxide. An example is depositing silicon oxide (such as SiO₂) or silicon nitride (such as Si₃N₄). A photoresist 173 can be deposited on the deposited inorganic material. A portion of the photoresist 173 can be removed by photolithographic techniques, exposing a portion of the deposited material. Accordingly, the exposed portion of the deposited material can be removed, e.g., by etching, to form the hard mask 172. Thereafter, the photoresist can be removed.

Fig. 2B shows forming of a plurality of trenches 120 in the semiconductor body. For example, the plurality of trenches 120 can be formed in a portion of the drift region 112 of the semiconductor body 101. An exemplary process for forming the plurality of trenches 120 is explained in connection with Fig. 2B. However, the present disclosure is not limited to this specific process. As it will become more apparent from the following description, the trenches 120 may form electrode trenches 120 in which electrodes are to be arranged. For example, the electrodes may be gate electrodes and/or field electrodes. An electrode may be electrically insulated from the semiconductor body 101 by a cavity formed around the electrode in trench 120.

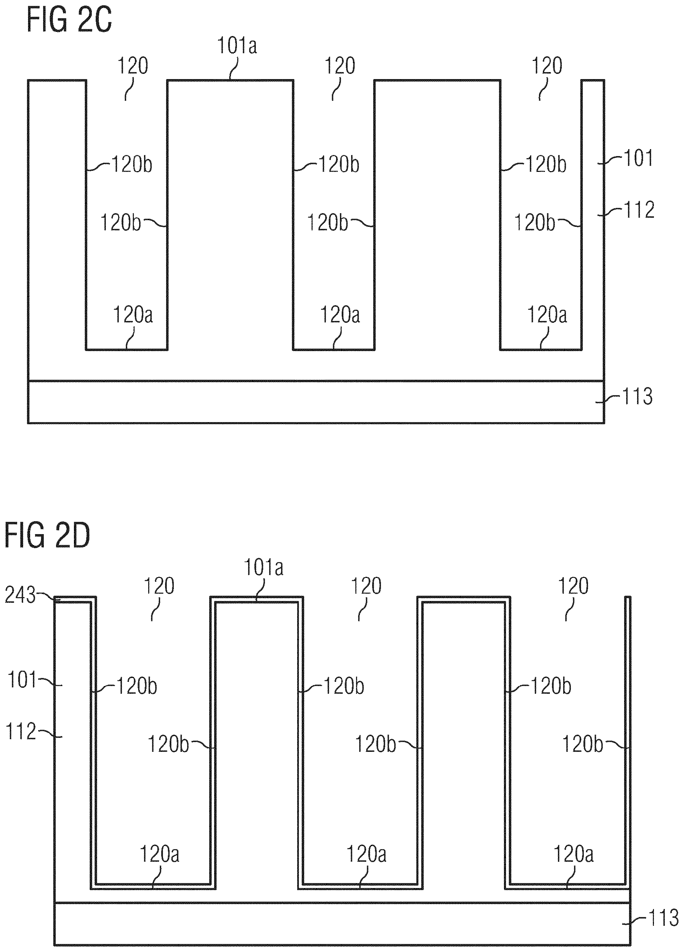

For instance, the plurality of trenches 120 can be formed in the exposed regions of the hard mask 172. Specifically, the plurality of trenches 120 can be formed by etching the semiconductor body 101 using the hard mask 172 as an etching mask. As shown in Fig. 2C, the hard mask 172 can be subsequently removed.

According to some embodiments, the trenches 120, specifically each of the trenches 120, can have a base 120a and a sidewall 120b extending from the base 120a to the first major surface 101a of the semiconductor body 101. The trenches 120, specifically each of the trenches 120, can have a depth of equal to or more than 0.1 µm measured in a vertical direction, and equal to or less than 20 µm. In case the trenches 120 are used as field plate trenches, the depth may be between 0.7 µm and 15 µm, for example. In case the trenches 120 are used as gate trenches, the depth may be between 0.15 µm and 3 µm, for example. The vertical direction may be orthogonal to the first major surface 101a of the semiconductor body 101.

Further, the trenches 120, specifically each of the trenches 120, can have a smallest lateral dimension (e.g., a width) in a first lateral direction. The smallest lateral dimension may be equal to or more than 0.1 µm and equal to or less than 4 µm. In case the trenches 120 are used as field plate trenches, the smallest lateral dimension may be between 0.2 µm and 4 µm, for example. In case the trenches 120 are used as gate trenches, the smallest lateral dimension may be between 0.5 µm and 2 µm, for example. The first lateral direction may be parallel to the first major surface 101a and may point in a direction that is given by the smallest distance between one side of a trench and an opposing side of the trench. According to some embodiments, the trenches 120 can be formed to have an aspect ratio of the depth to smallest lateral extension of at least 2:1, particularly of at least 4:1. The geometrical dimensions of the trenches 120, particularly the depth, are typically governed by the rated blocking voltage of the final device.

In a second lateral direction that is orthogonal to the first lateral direction and orthogonal to the vertical direction, the trenches 120 can have an elongated shape or the trenches 120 may have a lateral dimension that is substantially similar to the smallest lateral dimension. In the later case, the trenches 120 may be called columnar or needle-shaped trenches and may have one of a circular, a rectangular and an octagonal shape from a top view, for example.

In some optional embodiments a dielectric layer 243 is formed on the sidewall 120b and/or the base 120a of the trenches 120 as shown in Fig. 2D. Fig. 2D may show an enlarged view as compared to Figs. 2A to 2C. Dielectric layer 243 may comprise (e.g., be made of) one or more of silicon oxide, silicon nitride, aluminum oxide, titanium oxide, hafnium oxide, zirconium oxide, hafnium silicate, zirconium silicate, tantalum oxide, praseodymium oxide, lanthanum oxide, lanthanum aluminum oxide, niobium oxide, SiCOH, and a high-k material. For example, dielectric layer 243 may be formed by at least one of chemical vapor deposition, atomic layer deposition, and thermal oxidation. As discussed above with regard to Figure 1A, the second dielectric layer 243 is optional such that the process step shown in Fig. 2D may only be present in case presence of second dielectric layer 243 is desired.

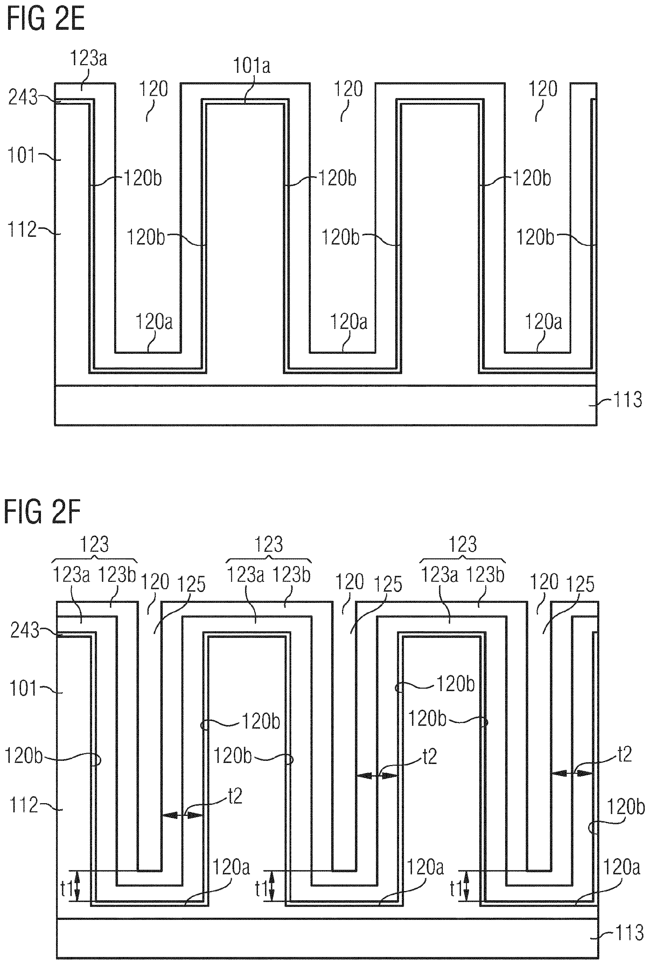

According to embodiments, an auxiliary structure 123 can be formed on the sidewall 120b and/or the base 120a of the trenches 120 (such as above the dielectric layer 243 if present). As shown in Fig. 2E, the auxiliary structure 123 comprises a first auxiliary layer 123a. The first auxiliary layer 123a can be formed by forming a first auxiliary material on the sidewall 120b and/or base 120a of the respective trenches 120. According to embodiments, the first auxiliary layer 123a can be a first insulating layer 123a and formed by using a first insulating material. For instance, the first auxiliary layer 123a can be formed by ALD (atomic layer deposition), CVD (chemical vapour deposition), HDP CVD (high-density plasma chemical vapour deposition), TEOS (Tetraethyl Orthosilicate) deposition, and/or PSG (phosphosilicate glass) deposition. In some examples, the first auxiliary layer 123a can be formed by thermal oxidation. Specifically, the first auxiliary layer 123a can be formed, e.g., to a thickness have a thickness of equal to or more than 30 nm, specifically equal to or more than 60 nm, typically equal to or more than 150 nm, and/or equal to or less than 700 nm, specifically equal to or less than 500 nm, typically equal to or less than 300 nm.

As shown in Fig. 2F, the auxiliary structure 123 can optionally include a second auxiliary material on the first auxiliary layer 123a to form a second auxiliary layer 123b on the first auxiliary layer 123a. Typically, the second auxiliary layer 123b completely covers the first auxiliary layer 123a. According to embodiments, the second auxiliary layer 123a can be a second insulating layer 123a and formed by using a second insulating material. The first and second insulating materials can be the same material or can be of different materials. The second auxiliary material can be deposited on the first auxiliary layer 123a. For instance, the second auxiliary layer 123b can be formed by ALD (atomic layer deposition), CVD (chemical vapour deposition), HDP CVD (high-density plasma chemical vapour deposition), TEOS (Tetraethyl Orthosilicate) deposition, BPSG (borophosphosilicate glass) deposition and/or PSG (phosphosilicate glass) deposition. The second auxiliary layer 123b can have a thickness of equal to or more than 30 nm, specifically equal to or more than 60 nm, typically equal to or more than 150 nm, and/or equal to or less than 700 nm, specifically equal to or less than 500 nm, typically equal to or less than 300 nm. According to some embodiments, the thickness of the first auxiliary layer 123a can be smaller than the thickness of the second auxiliary layer 123b.

According to some embodiments, the auxiliary structure 123 can be formed such to keep a hollow space 125 within the trenches 120, specifically within each of the trenches 120. Further, the auxiliary structure 123 can be formed to have a first thickness t1 at the base 120a of the trenches 120 and a second thickness t2 at the sidewall 120b. The first thickness t1 can be equal to the second thickness t2. According to some embodiments, the first thickness t1 is at least 2-time, particularly at least 3-times, larger than the second thickness t2. The thicknesses t1 and t2 are illustrated in Fig. 2F.

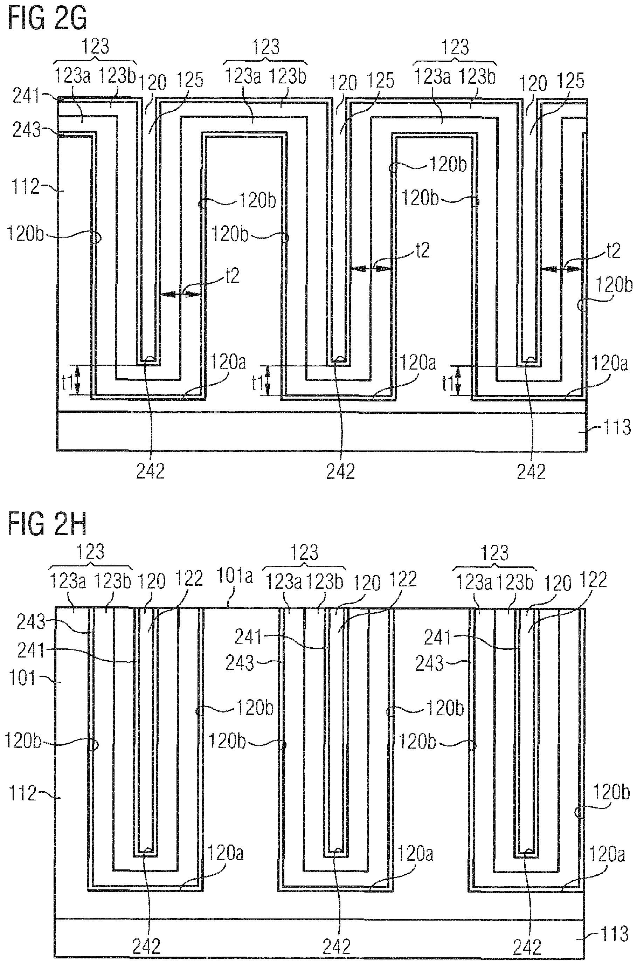

As shown in Fig. 2G, dielectric layer 241 is formed on auxiliary structure 123. Dielectric layer 241 may be the first dielectric layer discussed above with regard to Fig. 1A. First dielectric layer 241 may be disposed at least on a portion 242 of auxiliary structure 123. The first dielectric layer 241 may comprise (e.g., be made of) one or more of silicon oxide, and silicon nitride. The first dielectric layer 241 may have a thickness t that is greater than or equal to 2 nm and less or equal to 50 nm. In embodiments the thickness t of the first dielectric layer 241 may be less or equal to 30 nm. In embodiments the thickness t of the first dielectric layer 241 may be less or equal to 20 nm. In embodiments the thickness t of the first dielectric layer 241 may be greater or equal to 2.5 nm. In embodiments the thickness t of the first dielectric layer 241 may be greater or equal to 3 nm. In some embodiments, the first dielectric layer 241 has a thickness t that is greater than 2.5 nm and less or equal to 30 nm. In an embodiment, the first dielectric layer 241 has a thickness t hat is greater than 3 nm and less or equal to 20 nm. Dielectric layer 241 may comprise (e.g., be made of) one or more of silicon oxide, silicon nitride, aluminum oxide, titanium oxide, hafnium oxide, zirconium oxide, hafnium silicate, zirconium silicate, tantalum oxide, praseodymium oxide, lanthanum oxide, lanthanum aluminum oxide, niobium oxide, SiCOH, and a high-k material. For example, dielectric layer 243 may be formed by at least one of chemical vapor deposition, atomic layer deposition, and thermal oxidation.

The at least one portion 242 of the auxiliary structure 123 on which the first dielectric layer 241 is formed may be located where the auxiliary structure 123 has a curved shape (e.g., where the surface of the auxiliary structure 123 exhibits a curvature), such as where a sidewall of the auxiliary structure 123 meets the bottom of the auxiliary structure 123. In some embodiments, the first dielectric layer 242 is only disposed on the at least one portion 242 of the auxiliary structure 123. In other embodiments, the first dielectric layer 241 covers the auxiliary structure 123 completely.

As shown in Fig. 2H, the hollow space 125 of the respective trench 120 can be filled with a filling material 122, The filling material 122 may be deposited on the first side 101a of the substrate 101 to fill the trenches 120. According to embodiments, the filling material 122 can be an electrically conductive material for forming respective electrically conducting structures (such as an electrode) in the trenches 120.

As further shown in Fig. 2H, the first major surface 101a of the semiconductor body 101, specifically the filling material 122 and the auxiliary structure 123, can be polished, e.g., by a chemical-mechanical planarization (CMP) process or by an etching (such as wet chemical etch, dry etch, plasma etch). For instance, filling material 122 and the material of the auxiliary structure 123 above the first major surface 101a can be partially or completely removed, e.g. by the CMP process, to an extent that filling material 122 and material of the auxiliary structure 123 is partially or completely removed at and from the first major surface 101a of the semiconductor body 101 but left in the trenches 120. The CMP may process thus remove all filling material 122 and/or auxiliary material above the first major surface 101a so that a substantially flat surface is formed. The semiconductor material of the semiconductor body 101 can thus be exposed at the first major surface 101a.

The filling material 122 may form electrodes (such as field electrodes and/or gate electrodes) arranged in the trenches 120 in the final device. The filling material 122, specifically the electrically conductive material, can be a highly doped, e.g. n-type, polycrystalline semiconductor material, such as poly-Si, a metal stack, such as TiN, TiW and W, and/or combinations thereof.

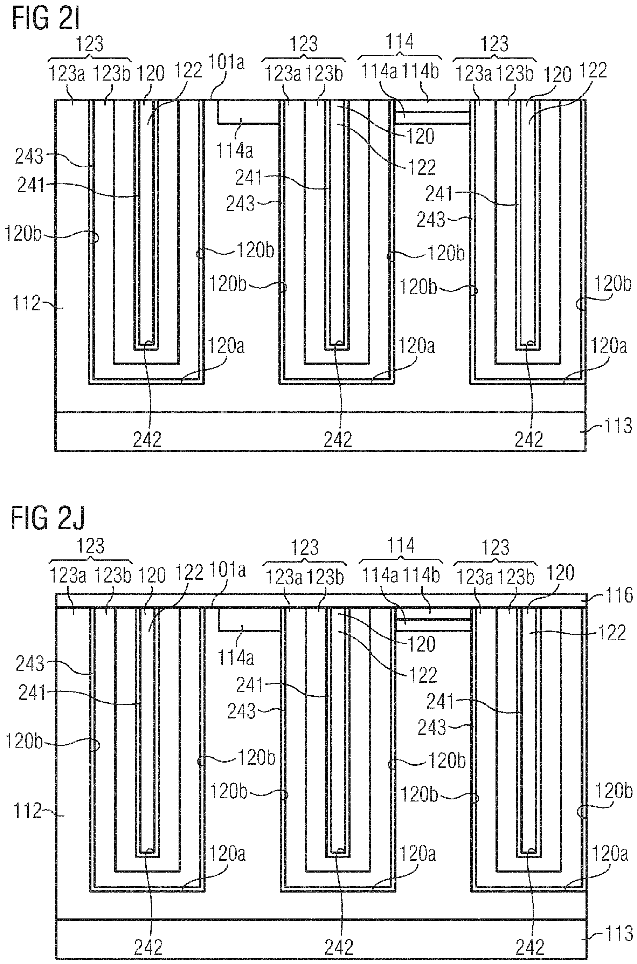

Continuing with Fig. 2I, at least one or more doping regions 114 can be formed in the semiconductor body 101. For instance, a plurality of doping regions 114 can be formed. Specifically, the doping regions 114 can be respectively formed between the pluralities of trenches 120. The steps shown and described with Fig. 2I are optional in the described process flow and could alternatively be performed before Fig. 2A (such that in Fig. 2A a source region 114a and a body region 114b would already be present).

The doping region 114 can include a body region 114a. Specifically, a dopant can be implanted into the drift region 112 to form a body region 114a having a conductivity type opposite to the conductivity type of the drift region 112. For instance, when the drift region 112 has an n-type doping, the body region 114a can be doped with a p-type dopant, and vice versa. Doping of the body region 114a can lead to a change of a semiconductor conductivity type, e.g. from n-type to p-type, and vice versa. For forming the body region 114a, a patterning process by lithographic methods including a photoresist and pattering the photoresist can be performed. After implantation, the photoresist can be removed and/or a thermal treatment can be performed (for instance, a body drive).

Further, the doping regions 114 can include a source region 114b. The source region 114b can be formed in at least some regions in which the body regions 114a were formed. For instance, the source region 114b can be respectively formed between the trenches 120. There may be also regions (such as where active transistor cells end) where only a body region 114a is present and that are devoid of a source region 114b. The source region may be of a doping type that is the same as the drift region 112 and that is opposite of the body region 114b. For forming the source region 114b, a further patterning process by lithographic methods including a photoresist and pattering the photoresist can be performed. According to embodiments, the absolute dopant concentration of the source region 114b can be higher than the dopant concentration in the body region 114a. Thereafter, the photoresist can be removed and/or a thermal treatment can be performed (such as a source drive). A common thermal treatment for the body region 114a and the source region 114b can also be carried out.

Fig. 2I shows exemplarily body implantation and source implantation. Typically, first p-dopants are implanted to form body regions 114a followed by implantation of n-dopants to form source regions 114b embedded into the body regions 114a.

As shown in Fig. 2J, a sealing structure 116 may be formed on the first major surface 101a of the semiconductor body 101. For example, the sealing structure 116 may comprise or consist of one or more insulating layers. Alternatively, the sealing structure 116 may comprise one or more contact structures that, e.g., may be used to contact filing structures 122. The sealing structure 116 may likewise comprise both one or more insulating layers and one or more contact structures. In Fig. 2J the sealing structure 116 is indicated by a single layer only for brevity.

In case the sealing structure 116 comprises more than one insulating layers 116, the plurality of insulating layers 116 can be deposited one after another. For instance, the sealing structure 116 can comprise at least one of a nitride layer, a polysilicon layer, and a BPSG layer. In other embodiments, the insulating layer 116 may comprise (e.g., be) just a single insulation layer 116 (e.g., at least one of a nitride layer and a polysilicon layer).

In case the sealing structure 116 comprises one or more contacting structures, at least one trench 122 can be closed, completely or partially, by the at least one contacting structure formed in an upper portion of the respective trench 120. The at least one contacting structure can cover the auxiliary structure 123 from one sidewall 120b to an opposing sidewall of the at least one trench 120. The upper portion of the filling structures 122 may by defined by an upper end of the sealing structure 116. For instance, the contacting structure can be formed by depositing a contacting material. The contacting material can be a highly doped, e.g. n-type, polycrystalline semiconductor material, such as poly-Si, a metal stack, such as TiN, TiW, and W, and/or combinations thereof.

According to an embodiment, the sealing structure 116 may be in contact with the filling structure 122 to provide mechanical support for the filling structure 122 during a later etching process.

According to embodiments, a plurality of contacting structures (of the sealing structure 116) can be formed in the trenches 120. For example, a respective (e.g., separate) contacting structure, can be formed in each of the trenches 120 if more than one trench 120 is formed. According to embodiments, the one or more contacting structures can be formed of an electrically conductive material which is in contact with the filling material 122. In other words, a respective one of the contacting structures may be in contact with a respective one of the filling structures 122 (which can be used as electrodes lateron).

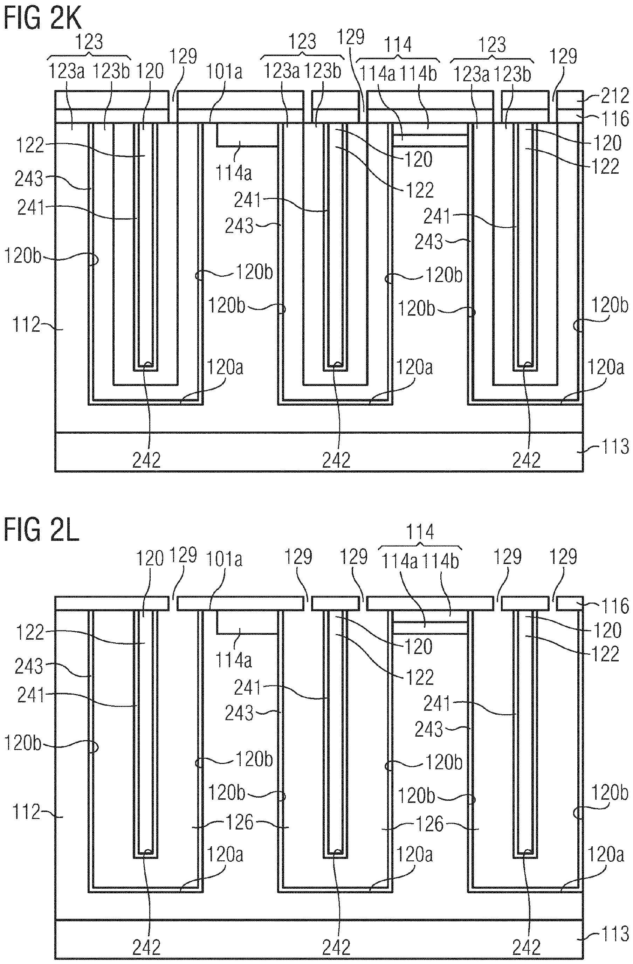

As shown in Fig. 2K, a photoresist 212 can be deposited on the semiconductor body 101, specifically the first major surface 101a of the semiconductor body 101. A portion of the photoresist 212 can be removed by photolithographic techniques, exposing a portion of sealing structure 116 (e.g., at least one of a portion of the one or more insulation layers and a portion of the contacting structures). Accordingly, the exposed portion of the sealing structure 116 may be removed, e.g., by etching, to form at least one opening 129 in sealing structure 116. The at least one opening 129 can partially expose the auxiliary structure 123, specifically an upper portion of the auxiliary structure 123. That is, the at least one opening can be formed in a region of sealing structure 116 that covers the auxiliary structure 123, i.e., that does not cover the filling material 122. Thereafter, the photoresist can be removed. For example, opening 129 may have a width of at least 0.1 µm, such as 0.2 µm.

In embodiments, more than one opening 129 can be formed in the sealing structure 116. Fig. 1A shows exemplary one opening 129 that is arranged in a first portion of the sealing structure 116. However, any desired number of openings 129 can be formed in the sealing structure 116, e.g. one, two, three, four, five, six etc per trench 120 or even more, like 10.

Continuing with Fig. 2L, the auxiliary structure 123 can be removed from the sidewall 120b of the trenches 120 and from at least a portion of the base 120a of the trenches 120. Specifically, the auxiliary structure 123 in the trenches 120 can be removed by using the at least one opening 129 as an access to the auxiliary structure 123 in the trenches 120. For instance, the auxiliary structure 123 in the trenches 120 can be etched using the openings 129 as an access through which the etching fluid can flow and reach the auxiliary structure 123 in the trenches 120 to remove the auxiliary structure 123 in the trenches 120. In embodiments, the material of auxiliary structure 123 (such as the first auxiliary layer 123a and the second auxiliary layer 123b) may be selectively etched as compared to the first dielectric layer 241 and the second dielectric layer 243. In other words, removing auxiliary structure 123 may not substantially alter the first dielectric layer 241 and/or the second dielectric layer 243. As such, the material of the auxiliary structure 123 may be different from the material of the first dielectric layer 241 and the second dielectric layer 243.

By removing the auxiliary structure 123, from the sidewall 120b and/or the base 120a of the respective trenches 120, cavities 126 can be formed in the trenches 120, specifically between the auxiliary structures 123 and the sidewall 120b of the trenches 120. Typically, one cavity 126 can be formed in each trench 120. However, more than one cavity 126 can be formed in each trench 120 as well. Specifically, the present disclosure provides trenches including a cavity 126.

The process steps as described above with Figs. 2A to 2L may be used to manufacture a device 100 as shown and discussed above with regard to Fig. 1A.

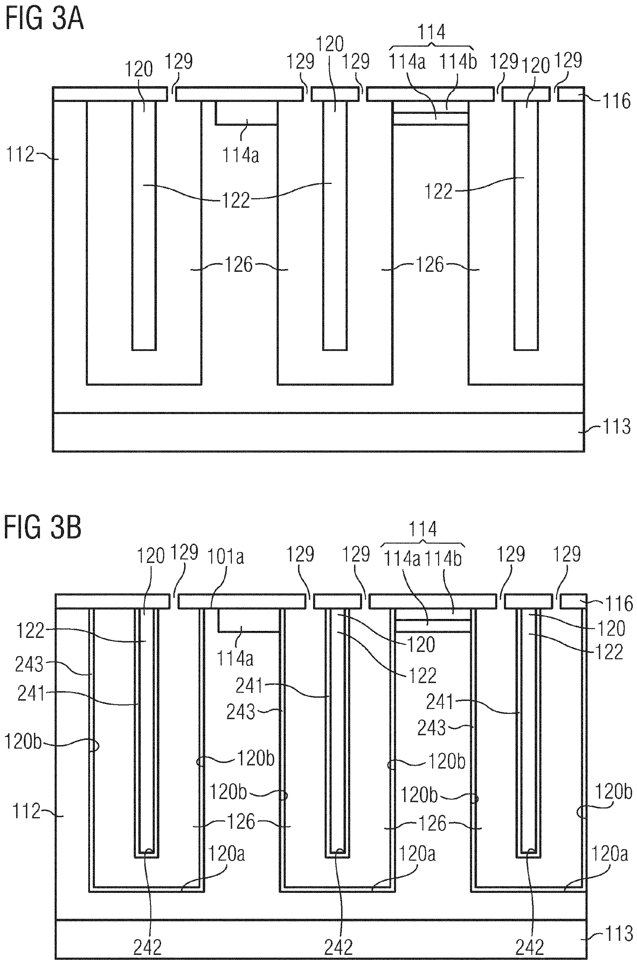

Figures 3A and 3B illustrate, in a cross-sectional view of a semiconductor body, process steps according to an embodiment. According to an embodiment, the process described above with regard to Figs. 2A to 2L may be altered. This altered process may likewise be used to manufacture a device 100 as shown and discussed above with regard to Fig. 1A. In particular, process steps 2D and 2G (of forming dielectric layer 243 and dielectric layer 241, respectively) may be omitted. Instead, dielectric layer 241 and dielectric layer 243 may be formed after the step shown and described with Fig. 2L.

Figure 3A illustrates a cross-sectional view of a semiconductor body, e.g., in case method steps 2A to 2L are performed when omitting the steps described with regard to Fig. 2D and 2F. The semiconductor body of Figure 3A is similar to the semiconductor body of Figure 2L but may lack the dielectric layer 241 and the dielectric layer 243.

Dielectric layer 241 and dielectric layer 243 may then be formed by inserting a dielectric material via opening 129 into cavity 126, as shown in Figure 3B. For example, dielectric layer 241 and dielectric layer 243 may be formed via thermal oxidation or via atomic layer deposition.

This may lead to a formation of dielectric layer 241 on a surface of filing material 122 (such as on its lower surface and its sidewalls). Similarly, this may lead to a formation of dielectric layer 243 on sidewall 120b and base 120a of trench 120.

The first dielectric layer 241 may have a thickness t that is greater than or equal to 2 nm and less or equal to 50 nm. In embodiments the thickness t of the first dielectric layer 241 may be less or equal to 30 nm. In embodiments the thickness t of the first dielectric layer 241 may be less or equal to 20 nm. In embodiments the thickness t of the first dielectric layer 241 may be greater or equal to 2.5 nm. In embodiments the thickness t of the first dielectric layer 241 may be greater or equal to 3 nm. In some embodiments, the first dielectric layer 241 has a thickness t that is greater than 2.5 nm and less or equal to 30 nm. In an embodiment, the first dielectric layer 241 has a thickness t that is greater than 3 nm and less or equal to 20 nm.

In embodiments, opening 129 has a width that is dimensioned such that it may be ensured that opening 129 is not closed during the insertion of the dielectric material that may form the dielectric layer 241 and dielectric layer 243. This may be useful to control a thickness of dielectric layer 241 and/or dielectric layer 243. In some embodiments the width of opening 126

In embodiments, opening 129 may have a width of at least 0.1 µm, such as 0.2 µm. For example, the width of opening 129 may be greater than at least one of the sum of the thickness t of the first dielectric layer 241 and a thickness of the second dielectric layer 242, twice the thickness of the first dielectric layer 241, and twice the thickness of the first dielectric layer 243.

The process as described with regard to Figs. 2A to 2L as well as the process described with regard to Figures 3A and 3B can be used for both forming a field plate and a gate electrode provided by filling material 122. In case a field plate is formed in the trench 120, an additional gate electrode may be provided adjacent to trench 120 (e.g., within an additional trench formed in doping region 114 or above doping region 114) or within the same trench 120.

Subsequently, (e.g., after performing the process steps described with regard to Figures 2A to 2L or after performing the process steps as described with regard to Figures 3A and 3B) the one or more openings 129 in sealing structure 116 may be closed or sealed with a plug 127. This may eventually result in a semiconductor device as shown in Fig. 1A. For instance, the at least one opening 129 in the sealing structure 116 can be closed or sealed by a BPSG reflow. Specifically, a BPSG layer can be formed on the sealing structure 116 providing at least one plug 127 to seal or close the one or more openings 129 in sealing structure 116. For example, the BPSG layer may be subjected to a temperature of equal to or greater than 800°C and/or equal to or smaller than 1100°C, typically to a temperature of about 950°C. The BPSG layer can be subjected to the temperature for a time of equal to or greater than 20 min and/or equal to or smaller than 60 min, typically for at time of about 40 min. The reflow process can be performed, without being limited thereto, in a gas and atmosphere of N2, O2, SF6, Ar, under high pressure, normal pressure, or vacuum conditions.

Alternatively, the at least one opening 129 may be closed or sealed by a deposition material which can be deposited on the semiconductor body 101, specifically on the first major surface 101a of the semiconductor body 101. The deposition material can fill the at least one opening 129, providing plug 127. The deposition material, specifically plug 127, can seal the at least one opening 129. The deposition material can include a metal, such as Ti, TiN, W, Al, AlCu, AlSiCu, Cu, Ta, Co, Pt, Au an oxide, such as TEOS, PSG, BPSG or USG, nitride, carbon, and semiconductor like Si and/or combinations thereof.

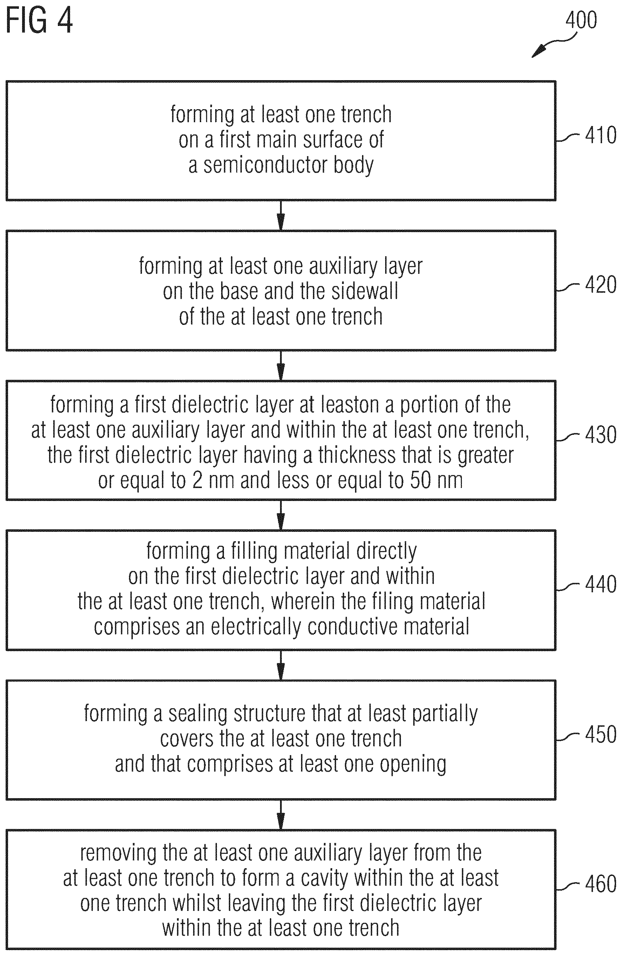

Figure 4 illustrates an exemplary method 400 according to an embodiment of the present disclosure. For example, the method steps may correspond to the process steps described above with regard to Figures 2A to 2L.

A method 400 for processing a semiconductor device 100 may comprise forming 410 at least one trench 120 on a first main surface 101a of a semiconductor body 101. The semiconductor body 101 may comprise a source region 114b of a first conductivity type, a body region 114a of a second conductivity type opposing the first conductivity type, and a drift region 112 of the first conductivity type. The at least one trench 120 may be formed in the semiconductor body 101 in a direction that is orthogonal to the first major surface 101a. The at least one trench 120 may comprise a sidewall 120b and a base 120a. The method 400 may further comprise forming 420 at least one auxiliary layer 123a, 123b on the base 120a and the sidewall 120b of the at least one trench 120. The method 400 may further comprise forming 430 a first dielectric layer 241 at least on a portion 243 of the at least one auxiliary layer 123a, 123b and within the at least one trench 120, the first dielectric layer 241 may have a thickness t that is greater or equal to 2 nm and less or equal to 50 nm. The method 400 may further comprise forming 440 a filling material 122 directly on the first dielectric layer 241 and within the at least one trench 120. The filing material 122 may comprise an electrically conductive material. The method 400 may further comprise forming 450 a sealing structure 116 that at least partially covers the at least one trench 120 and that comprises at least one opening 129. The method 400 may further comprise removing 460 the at least one auxiliary layer 123a, 123b from the at least one trench 120 to form a cavity 126 within the at least one trench 120 whilst leaving the first dielectric layer 241 within the at least one trench 120. In some embodiments method 400 may further comprise forming 470 one or more plugs 127 that cover the at least one opening 129of the sealing structure 116. In some embodiments the method 400 may further comprise after forming 410 the at least one trench 120 and before forming 420 the at least one auxiliary layer 123a; 123b, forming a second dielectric layer 243 on the base 120a and the sidewall 120b of the at least one trench 120 so that the at least one auxiliary layer 123a, 123b is formed on the second dielectric layer 243.

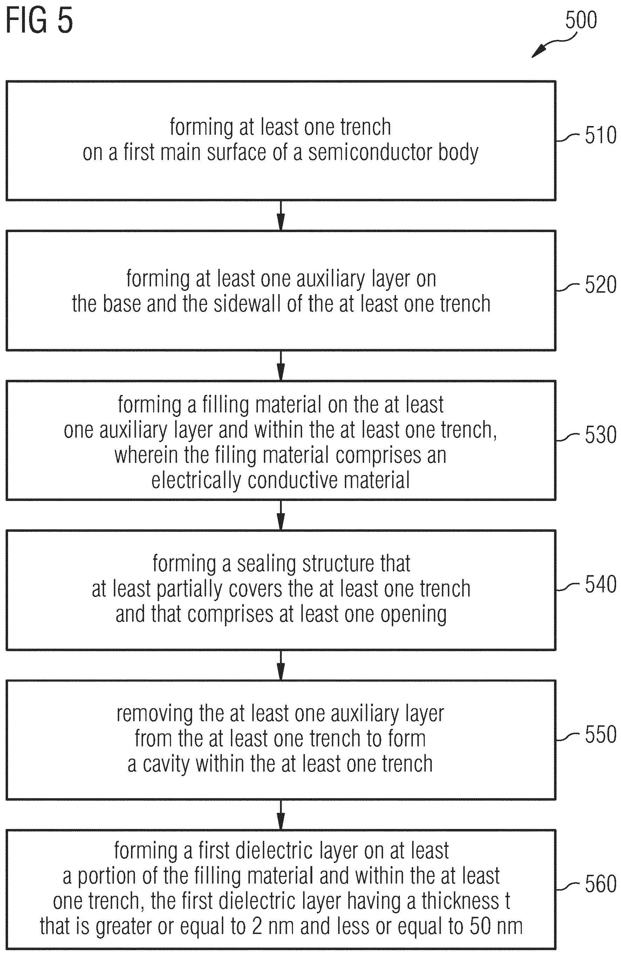

Figure 5 illustrates an exemplary method 500 according to an embodiment of the present disclosure. For example, the method steps may correspond to the process steps described above with regard to Figures 3A and 3B.

A method 500 for processing a semiconductor device 100 may comprise forming 510 at least one trench 120 on a first main surface 101a of a semiconductor body 101, the semiconductor body 101 comprising a source region 114b of a first conductivity type, a body region 114a of a second conductivity type opposing the first conductivity type, and a drift region 112 of the first conductivity type. The at least one trench 120 may be formed in the semiconductor body 101 in a direction that is orthogonal to the first major surface 101a. The at least one trench 120 may comprise a sidewall 120b and a base 120a. The method may further comprise forming 520 at least one auxiliary layer 123a, 123b on the base 120a and the sidewall 120b of the at least one trench 120. The method 500 may further comprise forming 530 a filling material 122 on the at least one auxiliary layer 123a, 123b and within the at least one trench 120. The filing material 122 may comprise an electrically conductive material. The method 500 may further comprise forming 540 a sealing structure 116 that at least partially covers the at least one trench 120 and that comprises at least one opening 129. The method 500 may further comprise removing 550 the at least one auxiliary layer 123a, 123b from the at least one trench 120 to form a cavity 126 within the at least one trench 120. The method 500 may further comprise forming 560 a first dielectric layer 241 on at least a portion 242 of the filling material 122 and within the at least one trench 120. The first dielectric layer 241 may have a thickness t that is greater or equal to 2 nm and less or equal to 50 nm. In some embodiments method 500 may further comprise forming 570 one or more plugs 127 that cover the at least one opening 126 of the sealing structure 116. In some embodiments, method 500 may further comprise when forming 560 the first dielectric layer 241 on the at least a portion 242 of the filling material 122, forming a second dielectric layer 243 at least on a portion of the sidewall 120b and/or the base 120a of the at least one trench 120.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A semiconductor device (100), comprising:
a semiconductor body (101) comprising a first major surface (101a), a source region (114b) of a first conductivity type, a body region (114a) of a second conductivity type opposing the first conductivity type, and a drift region (112) of the first conductivity type;
at least one trench (120) formed in the semiconductor body in a direction that is orthogonal to the first major surface, wherein the at least one trench comprises a sidewall (120b) and a base (120a);
an electrode (244) arranged in the at least one trench;
a cavity (126) arranged in the at least one trench and located between the electrode and at least a part of the drift region; and
a first dielectric layer (241) disposed at least on a portion (242) of the electrode, wherein the first dielectric layer has a thickness (t) that is greater or equal to 2 nm and less or equal to 50 nm.

2. The semiconductor device (100) of claim 1, further comprising:
a second dielectric layer (243) disposed at least on a portion of the sidewall (120b) and/or the base (120a) of the at least one trench (120).

3. The semiconductor device (100) of claim 2, further comprising:
a sealing structure (116), covering the cavity (126), wherein the sealing structure comprises an opening (129) that is filled with a plug (127), and wherein the opening has a width that is greater than the sum of the thickness (t) of the first dielectric layer (241) and a thickness of the second dielectric layer (243).

4. The semiconductor device (100) of any of the preceding claims, wherein the first dielectric layer (241) comprises at least one of silicon oxide, silicon nitride, aluminum oxide, titanium oxide, hafnium oxide, zirconium oxide, hafnium silicate, zirconium silicate, tantalum oxide, praseodymium oxide, lanthanum oxide, lanthanum aluminum oxide, niobium oxide, SiCOH, and a high-k material.

5. The semiconductor device (100) of any of the preceding claims, wherein the portion (242) of the electrode (244) on which the first dielectric layer (241) is disposed has a curved shape.

6. The semiconductor device (100) of any of the preceding claims, wherein the electrode (244) is at least one of a field plate and a gate electrode.

7. The semiconductor device (100) of any of the preceding claims, wherein the semiconductor body (101) is made of at least one of silicon, silicon carbide, and gallium nitride.

8. The semiconductor device (100) of any of the preceding claims, wherein the thickness (t) of the first dielectric layer (241) is less or equal to 30 nm.

9. The semiconductor device (100) of any of the preceding claims, wherein the thickness (t) of the first dielectric layer (241) is less or equal to 20 nm.

10. The semiconductor device (100) of any of the preceding claims, wherein the thickness (t) of the first dielectric layer (241) is greater or equal to 2.5 nm.

11. The semiconductor device (100) of any of the preceding claims, wherein the thickness (t) of the first dielectric layer (241) is greater or equal to 3 nm.

12. A method (400) for processing a semiconductor device (100), the method comprising:
forming (410) at least one trench (120) on a first main surface (101a) of a semiconductor body (101), the semiconductor body comprising a source region (114b) of a first conductivity type, a body region (114a) of a second conductivity type opposing the first conductivity type, and a drift region (112) of the first conductivity type, the at least one trench being formed in the semiconductor body in a direction that is orthogonal to the first major surface and comprising a sidewall (120b) and a base (120a),
forming (420) at least one auxiliary layer (123a; 123b) on the base and the sidewall of the at least one trench;
forming (430) a first dielectric layer (241) at least on a portion of the at least one auxiliary layer and within the at least one trench, the first dielectric layer having a thickness (t) that is greater or equal to 2 nm and less or equal to 50 nm;
forming (440) a filling material (122) directly on the first dielectric layer and within the at least one trench, wherein the filing material comprises an electrically conductive material;
forming (450) a sealing structure (116) that at least partially covers the at least one trench and that comprises at least one opening (129); and
removing (460) the at least one auxiliary layer (123a; 123b) from the at least one trench to form a cavity (126) within the at least one trench whilst leaving the first dielectric layer (241) within the at least one trench.

13. The method (400) of claim 13, further comprising:
after forming (410) the at least one trench (120) and before forming (420) the at least one auxiliary layer (123a; 123b), forming a second dielectric layer (243) on the base (120a) and the sidewall (120b) of the at least one trench so that the at least one auxiliary layer is formed on the second dielectric layer; and/or
after removing (460) the at least one auxiliary layer (123a; 123b), forming (470) one or more plugs (127) that cover the at least one opening of the sealing structure.

14. A method (500) for processing a semiconductor device (100), the method comprising:
forming (510) at least one trench (120) on a first main surface (101a) of a semiconductor body (101), the semiconductor body comprising a source region (114b) of a first conductivity type, a body region (114a) of a second conductivity type opposing the first conductivity type, and a drift region (112) of the first conductivity type, the at least one trench being formed in the semiconductor body in a direction that is orthogonal to the first major surface and comprising a sidewall (120b) and a base (120a),
forming (520) at least one auxiliary layer (123a; 123b) on the base and the sidewall of the at least one trench;
forming (530) a filling material (122) on the at least one auxiliary layer and within the at least one trench, wherein the filing material comprises an electrically conductive material;
forming (540) a sealing structure (116) that at least partially covers the at least one trench and that comprises at least one opening (129);
removing (550) the at least one auxiliary layer from the at least one trench to form a cavity (126) within the at least one trench; and
forming (560) a first dielectric layer (241) on at least a portion (242) of the filling material and within the at least one trench, the first dielectric layer having a thickness t that is greater or equal to 2 nm and less or equal to 50 nm.

15. The method (500) of claim 14, further comprising:
when forming (560) the first dielectric layer (241) on the at least a portion (242) of the filling material (122), forming a second dielectric layer (243) at least on a portion of the sidewall (120b) and/or the base of the at least one trench (120); and/or
after forming (560) the at least one auxiliary layer (123a; 123b), forming one or more plugs (127) that cover the at least one opening of the sealing structure.
